Europäisches Patentamt

European Patent Office

Office européen des brevets

(11) Numéro de publication: **0 117 968**
**B1**

## (12) FASCICULE DE BREVET EUROPEEN

(45) Date de publication du fascicule du brevet: **02.09.87**

(51) Int. Cl.⁴: **C 25 D 1/14**

(21) Numéro de dépôt: **83870141.5**

(22) Date de dépôt: **28.12.83**

(54) Procédé électrochimique de mise à forme directe de pièces généralement minces aux contours et surfaces variés en céramique traditionnelle et technique ou en réfractaire.

(30) Priorité: **27.01.83 BE 895717**

(43) Date de publication de la demande:
**12.09.84 Bulletin 84/37**

(45) Mention de la délivrance du brevet:
**02.09.87 Bulletin 87/36**

(84) Etats contractants désignés:
**BE DE FR GB IT LU NL**

(56) Documents cités:
**EP-A-0 022 113**
**FR-A-2 036 218**
**US-A-3 419 901**

(73) Titulaire: **ANDROMAQUE S.A.**
**121 Avenue de la Faiencerie**
**L-1511 Luxembourg (LU)**

(72) Inventeur: **Van der Poorten, M.**
**rue Vandervelde 277**
**B-7000 Mons (BE)**

(74) Mandataire: **Colens, Alain M.G.M.**
**BUGNION S.A. Rue de Namur 43-b.3**
**Naamsestraat**
**B-1000 Bruxelles (BE)**

Courier Press, Leamington Spa, England.

## Description

La présente invention est relative à un procédé pour la réalisation de carreaux céramiques individuels ou intégrés dans un ensemble de carreaux céramiques minces sans moule ni estampage ultérieur d'un ruban de pâte, cet estampage conduisant toujours à une perte évaluée à environ 10%. Ces carreaux sont fabriqués en cru, avec des contours rectilignes ou à découpes variées avec bords spontanément arrondis. Ils peuvent être réalisés plats ou présenter des profils dans l'espace. Leur surface peut être lisse, regueuse ou avec une impression en léger relief. De plus, la technique permet d'y incorporer des textes, dessins ou photographies avec des détails même très fins, ceci en relief (ou en creux), ces motifs étant réellement incrustés dans les carreaux céramiques; il peut s'agir également de la fabrication de substrats pour l'électronique et l'électrotechnique. Il s'agit de performances réellement nouvelles vis-à-vis des procédés antérieurs.

Dans le brevet belge no. 873 378 du même auteur, on a décrit un procédé électrochimique permettant à la fois le coulage, le moulage, le profilage, l'usinage et le traitement de surface de pièces à partir de matières premières sous forme de suspensoïdes chargés et donnant lieu à des électro-dépôts conducteurs par réaction d'électrode rigoureusement contrôlée.

En outre dans le brevet belge no. 880 933 également du même auteur, sont décrites des mises en oeuvre complémentaires de la technique des électro-dépôts de matières céramisables, vitrifiables, frittables ou polymérisables sur des supports ou moules métalliques, ainsi qu'à l'utilisation d'échangeurs d'ions comme surface de coulage électrochimique et notamment à son application particulière à la fabrication de verre plat.

Avant de détailler ces nouveaux principes originaux, rappelons que les techniques classiques des fabrications céramiques conduisant à des produits similaires utilisent en ordre principal les techniques de pressage, d'étirage, de coulage entre deux plâtres.

Le pressage nécessite la fabrication très onéreuse de moules en métaux très spéciaux et coûteux ne permettant que peu la diversification des formes et des modèles, le prix de ces moules exigeant la production de grandes séries de modèles répétitifs. De plus, il est pratiquement impossible de réaliser par cette technique des carreaux minces (par exemple de 3 à 5 mm d'épaisseur) de grands formats tels que 60×60 cm par exemple. Le réalisation de bords arrondis exige l'usinage particulier des moules.

L'étirage à plat est utilisé, mais il nécessite un estampage ultérieur pour mettre à forme sans possibilité d'arrondi des bords; de plus, les grands formats minces sont peu réalisables par cette seconde technique.

Le coulage en moule de plâtre (entre deux parois) n'est pas utilisable pour des carreaux; pour de grands formats minces, le remplissage des moules avec la barbotine présente des problèmes et de plus, les moules de plâtre très lourds sont fragiles et demandent en séchage contrôlé après coulage.

Pour des applications en électrotechnique, les substrats électroniques sont réalisés par la technique dite "Doctor blade" permettant la fabrication de supports d'alumine minces; mais cette technique n'est pas adaptable à la fabrication d'éléments mis à forme individuellement.

Enfin, si le pressage permet d'imprimer un motif dans les carreaux, le prix de la fabrication des moules devient de plus en plus prohibitif si on s'adresse à des motifs compliqués, variés et à détails très fins. Les matières premières utilisées pour le pressage sont par ailleurs mal adaptées pour la reproduction de tels motifs.

Par étirage, cette impression directe de motifs est vraiment irréalisable. Avec des moules de plâtre, le coulage des plaques avec motifs de décoration très fins est très délicat, la fabrication des moules eux-mêmes présentant des problèmes.

Enfin, la transposition de dessins, textes ou photographies sur céramiques est réalisée classiquement par des techniques de collage de décalcomanies ou par enduit d'une gélatine photosensible sur biscuit. Ces procédés ne réalisent pas vraiment une incrustation des motifs et pour les photographies, il ne s'agit que d'un placage réalisé avec des encres céramiques.

Quant à la technique de fabrication de céramique en pâte molle par électrophorèse avec le système du "double dépôt", les machines décrites dans la littérature brevets correspondante ne produisent qu'un ruban de pâte à estamper ultérieurement sans conditionnement de bords, ni relief, ni incorporation de motifs de décoration.

La présente invention concerne un procédé électrochimique pour la réalisation de carreaux céramiques individuels ou intégrés dans un ensemble de carreaux céramiques, sans moule ni estampage ultérieur d'un ruban de pâte, d'épaisseurs comprises entre 1 et 15 mm. et dont les formats par élément individuel peuvent s'inscrire dans des surfaces jusqu'à 1000×1000 mm., les ensembles de carreaux étant du type "mosaiques", "vitraux" ou "puzzles", procédé comportant l'électrodéposition des matières premières en barbotine sur l'anode d'une cuve d'électrolyse et dans lequel ou utilise une pluralité de membranes échangeuses d'ions ou semiperméables ou de plaques métalliques planes ou profilées que l'on place individuellement dans la cuve d'électrolyse devant une cathode fixe, les dites membranes ou plaques étant selectivement masquées à l'aide de peinture isolante ou de ruban auto-adhésif délimitant les contours des carreaux à réaliser.

La présente invention concerne également un dispositif pour la mise en oeuvre de ce procédé, comme defini à la revendication 10.

Les plaques métalliques planes ou profilées sont constituées de préférence de zinc, de matière galvanisée, de cuivre, de fer, d'aluminium, de laiton, d'acier inoxydable, de magnésium ou de nickel.

Le contour des carreaux est dessiné sur ces plaques à l'aide d'un trait de peinture isolante ou de ruban auto-adhésif isolant dont la largeur préfigure les joints qui subsisteront entre les carreaux cuits lors de leur placement.

Cette technique consiste donc à réaliser un masquage sélectif des anodes réalisant une isolation électrique locale et par conséquent une "réserve" où aucun dépôt ne se fera lors de l'électrolyse. Ce masquage sélectif peut aussi être réalisé sur les membranes échangeuses d'ions ou semi-perméables. Les pièces de céramique électrodéposées aux endroits non isolés se développent jusqu'aux contours isolés. Aux limites isolées, la matière électrodéposée prend un arrondi spontané conformément à la distribution des lignes de courant électrique aux frontières entre zones conductrices et isolantes.

Il est possible, par les moyens utilisés classiquement en galvanoplastie, d'exploiter l'effet de bord soit pour réaliser volantairement une légère surépaisseur sur le pourtour des carreaux ou pour atténuer cet effet.

Afin de mieux comprendre l'invention, on la décrit à titre d'exemple et non limitatif par rapport à des dessins qui représentent:

à la figure 1a, un carreaux avec bord en surépaisseur;

à la figure 1b, deux carreaux côte à côte sans effet de surépaisseur;

à la figure 2a, une plaque préparée pour former de petits carreaux réguliers;

à la figure 2b, une plaque préparée pour former des carreaux réguliers mais de plus grands formats qu'à la figure 2a;

à la figure 2c, un ensemble de plaques préparées pour former un ensemble de carreaux réalisant un motif type "vitrail";

à la figure 2d, une plaque préparée pour des carreaux type "puzzle" dont certains éléments présentent de réels emboîtements;

à la figure 3a, un carreau galbé;

à la figure 3b, un carreau en équerre;

à la figure 3c, un carreau en cornière;

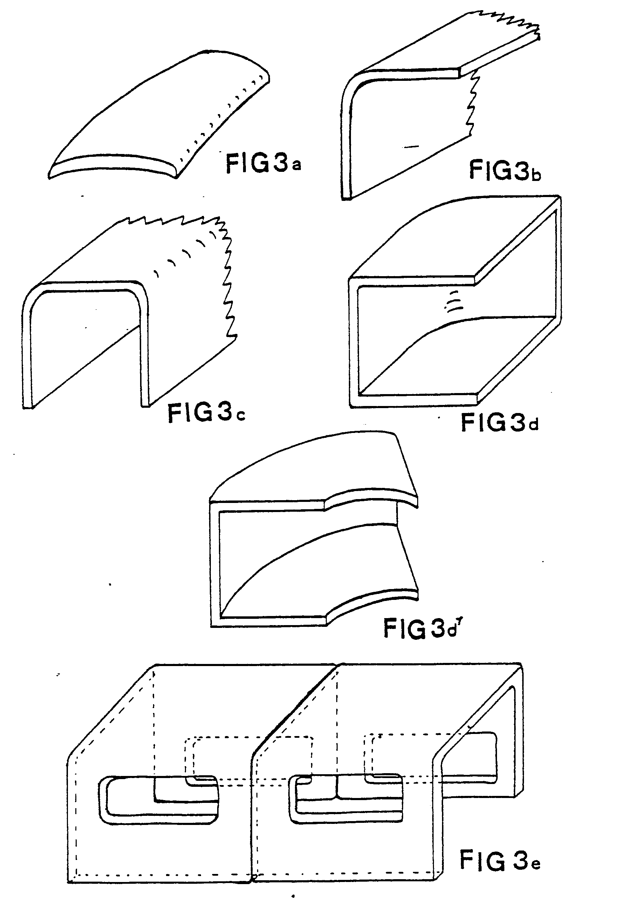

aux figures 3d et 3d', des carreaux en coins;

à la figure 3e, deux carreaux de claustra;

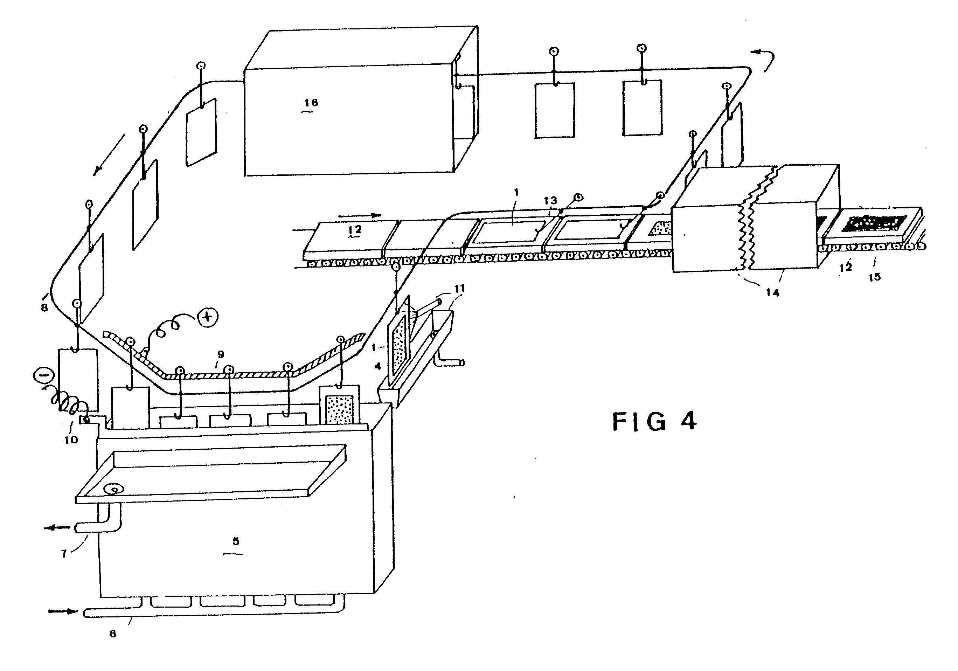

à la figure 4, une vue schématique d'un dispositif de fabrication continue pour la mise en oeuvre selon la présente invention.

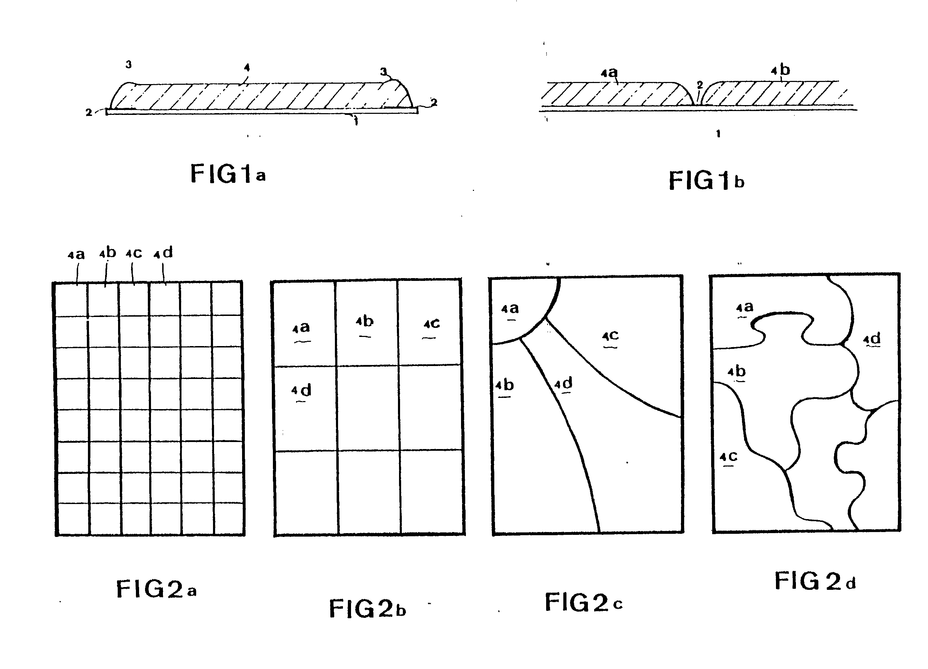

Sur la figure 1a, où est représenté un carreau (4) avec bord en surépaisseur (3), la plaque métallique (1) est isolée en (2).

En 2b, il s'agit de deux carreaux (4a, 4b) formés côté à côte sans effet de surépaisseur, la plaque métallique (1) étant isolée en (2).

Selon le format des plaques qui peut aller, à titre d'exemple, de 10×10 cm jusqu'à 100×100 cm, il est possible de réaliser des ensembles (figures 2a à 2d) de carreaux (4a, 4b, 4c, . . .) aux contours variés comme représentés sur la figure 2a, où il s'agit d'une plaque (1) préparée pour fabriquer de petits carreaux réguliers type mosaïque. A la figure 2b, il s'agit d'une plaque utilisée pour des carreaux (4a, 4b, 4c, . . .) aux bords toujours rectilignes mais de plus grands formats. Individuellement, il est possible de réaliser des carreaux de format 75×75 cm d'épaisseur de 1 à 5 mm pour usage mural. Des épaisseurs jusqu'à 15 mm sont réalisables pour application au sol.

A la figure 2c, il s'agit, uniquement à titre d'exemple de plaques préparées pour des ensembles de carreaux (4a, 4b, 4c, . . .) réalisant un motif type "vitrail" dont la forme et la dimension des éléments peut varier à l'infini.

A la figure 2d, la plaque (1) est préparée pour des carreaux (4a, 4b, 4c . . .) type "puzzle" dont certains éléments présentent de réels emboîtements.

Il reste à noter que ces ensembles sont fabriqués en une seule opération, celle-ci demandant par exemple 3 minutes d'électrolyse.

Pour les motifs n'ayant ni axe ni centre de symétrie, la préparation de modèles droit et gauche peut s'avérer intéressante pour développer les motifs muraux ou de sols dans les deux dimensions avec possibilité de raccordement des joints entre les divers éléments des motifs.

La préparation des plaques (1) s'effectue très aisément et permet donc de rendre la technique très souple et de varier les modèles à très peu de frais, puisqu'il s'agit simplement de changer un dessin sur les plaques.

Si l'on utilise de la peinture isolante, celle-ci peut être posée avec un pinceau à main levée ou à l'aide d'un pochoir ou par la technique de sérigraphie sur l'anode, les endroits de l'anode non recouverts définissant la forme du ou des carreaux fabriqués, lez zones isolées déterminant les espaces vides autour, entre les carreaux ou des vides à l'intérieur de ceux-ci. Avec des rubans adhésifs de largeur bien calibrée, le même effet est obtenu et il est donc également possible de préparer des plaques très facilement et très rapidement.

Les plaques planes (1) étant utilisées pour fabriquer des carreaux plats, il est possible de fabriquer des structures dans l'espace en donnant des formes quelconques à la plaque soit par emboutissage, cintrage, pliage, soudure. La technique conduit dans ce cas à la fabrication de profilés d'épaisseur de 1 à 5 mm. et par exemple, certaines formes réalisables telles que carreaux galbés (figure 3a), en équerre (figure 3b), en cornières (figure 3c), en coins (figures 3d, 3d'), de claustra (figure 3e), de tubes droits ou coudés, les contours de ces structures étant toujours délimités pur la technique du masquage sélectif des tôles métalliques ou des membranes à l'aide de peinture ou de rubans isolants.

Des carreaux avec surface rugueuse plus ou moins irrégulière imitant la pierre ponce ou la lave peuvent être obtenus sur des anodes constituées de dépôts métalliques projetés à chaud au pistolet ou au chalumeau à plasma et par la technique du zinguage au pistolet à chaud sur support métallique ou en matière plastique. A titre d'exemple la métallisation sur pareil support au pistolet à zinc fondu convient très bien pour réaliser des anodes convenant pour ce genre de carreau à surface rugueuse irrégulière.

Des "bas-reliefs" en céramique de 3 à 10 mm d'épaisseur peuvent ainsi être réalisés sur des anodes formées de tôles repoussées ou martelées en les divers métaux cités précédemment. Des supports moulés ou emboutis en matériaux polymères organiques métallisés en surface à l'aide d'une peinture conductrice (Zn, Cu, Ag, Ni) ou d'une métallisation par méthode chimique (exemples: cuivre, nickel, argent) permettent la reproduction par double moulage (négatif, positif) de bas-reliefs existants. Des plaques avec relief obtenues par électroformage ou électro-usinage en divers métaux sont également utiles pour cette production de bas-reliefs. Ceux-ci peuvent avoir de 3 à 10 mm d'épaisseur.

La gravure préalable des plaques métalliques soit mécaniquement soit par attaque acide (technique de l'eau forte ou de la photogravure sur plaque de zinc, cuivre, magnésium) permet la transposition sur la céramique de motifs en creux ou en relief très variés.

Par photogravure sur plaque métallique de zinc, de cuivre ou de magnésium, c'est la plaque de photogravure elle-même qui sert d'anode pour fabriquer le carreau. Dans ces cas, c'est bien entendu la face du carreau contre l'anode qui comporte le gravure.

On reproduit ainsi aussi bien du texte que des dessins avec traits ou des photographies de paysages, de personnages, de tableaux, etc.. Dans ces derniers cas, les clichés reproduits par photogravures subissent l'opération de "tramage" avec des trames de toute espèce.

Les photographies sont reproduites sur la céramique avec un relief correspondant à la profondeur de gravure des plaques métalliques. Selon les cas, on prendre les clichés négatifs ou les diapositives pour l'insolation des plaques de photogravure.

Les photographies sont ainsi véritablement incrustées en relief dans la céramique, ceci avec des détails très fins.

Après cuisson, il est possible de révéler les photographies par encrage au rouleau avec des encres d'imprimerie ordinaire ou avec des encres céramiques ou émaux colorés.

Par sérigraphie, on peut travailler avec plusieurs encres ou émaux de couleurs différentes et reproduire ainsi des photographies en couleurs. On peut égament appliquer des oxydes colorants aux carreaux après cuisson.

Des documents importants (reproduction de texte ou de toute oeuvre d'art) peuvent ainsi être conservés dans des formes résistant aux incendies.

Ces reproductions peuvent être effectuées sur les carreaux plats ou profilés; il suffit pour ce faire soit d'utiliser les plaques gravées comme électrode, soit d'incorporer les plaques gravées dans les électrodes de plus grand format pour réaliser un ensemble d'éléments céramiques dont tous ou certains seulement comporteront la reproductions d'un motif.

Des reliefs atténués peuvent être obtenus sur les carreaux du côté opposé à celui qui est en contact avec le métal. On utilise pour ce faire une propriété que l'auteur a découverte par l'étude fondamentale du mécanisme de l'électrodéposition de céramique à savoir qu'ainsi la nature du métal et la forme du dépôt d'une couche mince d'un métal d'apport sur la plaque support influence la vitesse d'électrodéposition de la céramique. Il est dès lors possible d'exploiter cette propriété pour obtenir du relief. Il suffit en effet de réaliser selon un dessin préétabli, un dépôt métallique à certains endroits de l'électrode. Si le métal apporté est de nature à accélérer la vitesse d'électrodéposition, à ces endroits il apparaîtra un relief sur la surface extérieure du dépôt. Si le métal superposé à l'électrode est au contraire de nature à ralentir la vitesse d'électrodéposition, il apparaîtra en correspondance avec ces endroits des creux sur la surface extérieure du carreau. A titre d'exemple, le cuivrage localisé sur plaque de zinc produira des creux dans la céramique. Inversement, sur plaque de cuivre, les dépôts de zinc localisés provoqueront des zones en relief. Les couples Zn-Al, Cu-Al, Zn-Al ainsi que Fe-Zn sont exploitables pour réaliser ces reliefs atténués qui présentent les très grand avantage d'être obtenus sur des électrodes qui restent pratiquement planes. Les dépôts métalliques en surépaisseur sur les plaques se font en effet sous des épaissuers restant inférieurs au 1/10 ième de mm.

Les plaques métalliques sont préparées par les techniques habituelles de la galvanoplastie après isolement des parties de la tôle de base qui ne sont pas à récouvrir par un dépôt d'un autre métal.

On peut aussi réaliser ces plaques bi- ou polymétalliques à l'aide de bain de dépôts chimiques sur support éventuellement non métallique.

A l'aide de carreaux plats aux contours variés et les éléments profilés, avec motifs gravés ou non, il est possible de constituer des "sets" de carreaux adaptables à toute forme de tables de cuisine, éviers encastrés, tablettes de fentêtre, éléments de cuisine intégrés, accessoires de salles de bains (poignées de robinets, de portes, boutons, supports-savons, etc..), de pieds de lavabos, de revêtements de tables de salon artistique.

La mise en oeuvre de la présente invention peut se faire dans un dispositif de fabrication continue (figure 4). Ce schéma correspond plus particulièrement à un dispositif pour la fabrication de grands carreaux plats. Il peut être facilement adapté à la production des autres types de pièces décrits dans le présent texte, notamment pour la réalisation, en une seule opération, de panneaux en carreaux céramiques type mosaïque, vitraux ou puzzle à des dimensions pouvant aller jusqu'à 1×1 m.

Sur cette figure 4, on a représenté en (5) la cellule d'électrolyse dont les dimensions peuvent être, à titre d'exemple, de 3 à 6 m de longueur, de 15 à 20 cm de largeur et de 1 m à 1 m 50 de hauteur. En (6) figure l'entrée et la distribution de la barbotine d'alimentation; en (7) l'évacuation de cette barbotine qui retourne à la cuve d'électrolyse.

Les plaques (1) servant d'anodes sont transportées sur un convoyeur (8); à l'entrée dans la cellule, elles sont mises sous tension grâce au rail (9) et du contact glissant ou tournant dont chaque plaque est munie. La contre-électrode fixe constamment immergée dans le bain et servant de cathode est située en (10). Après électrodéposition, les plaques chargées sont sorties de la cellule et passent au poste d'égouttage et de lavage à l'eau en (II).

En (13) les plaques (1) chargées des carreaux crus (4), sont déposées sur des dalles de cuisson (12) en matériau réfractaire poussées sur des rouleaux servant d'abord comme support pour receuillir les carreaux crus qui sont détachés ensuite des plaques électrodes après un temps à adapter à chaque type de pâte et aux conditions d'électrolyse.

Tandis que les plaques électrodes se dégagent en suivant le convoyeur, les carreaux libérés et posés sur les dalles réfractaires pénètrent dans le four tunnel à rouleaux en (14) servant à la fois pour le séchage et pour la cuisson. En (15) on récupère les carreaux cuits. En (16) les plaques subissent un nettoyage et un reconditionnement avant de retourner dans la cellule d'électrolyse.

L'émaillage non représenté à la figure 4 peut être incorporé dans la chaîne de fabrication. Il peut être effectué en cru (avant cuisson) soit par pulvérisation de barbotine d'émail soit par la technique du rouleau encreur. Dans ce cas, c'est la face du carreau côté électrode qui est le plus aisément émaillable. Avec un émail posé au pistolet, il est possible d'émailler ainsi en une couleur les carreaux avec gravure.

L'émaillage en bicuisson sur biscuit (donc après le passage au four de cuisson) sera mieux indiqué pour un émaillage de l'autre face des carreaux ou pour l'émaillage à plusieurs couleurs par les techniques décrites ci-dessus dans la présente demande de brevet ou encore pour la coloration et l'émaillage polychrome des pièces avec motifs divers en relief.

L'électrodéposition pouvant se faire en des temps compris par exemple entre 1 et 5 minutes pour les épaisseurs de 1 à 5 mm, c'est surtout le séchage et la cuisson qui constituent l'étape lente du procédé de fabrication des carreaux finis.

Si la capacité du four le permet, il est possible avec une cellule d'environ 6 m de longueur, de fabriquer une plaque de 1 m×1 m à la minute dans une chaîne avançant à la vitesse de 1 m par minute. A ce rythme, une seule cellule pourrait donc alimenter la chaîne de fabrication de carreaux à raison d'environ 50 m² utiles à l'heure ou 1200 m² par 24 heures, ce qui pourrait conduire à une production de 250 000 m² par an. La chaîne comprendrait une trentaine de plaques dont la fréquence de renouvellement dépend de la réserve de métal utile. S'il s'agit de zinc par exemple, il faut compter une consommation d'environ 400 μm en 24 heures de temps utile (c'est-à-dire de temps d'immersion). La diminution d'épaisseur des plaques de zinc d'environ 400 μm s'effectuerait donc pout les 30 plaques dont 5 seulement sont immergées à la fois sur une durée de 6×24 heures.

Durant un tel cycle de 6×24 heures=144 heures, on consommerait pour les 30 plaques (30 m²) et pour la production de 6×1200=7200 m² de carreaux de 5 mm d'épaisseur (soit environ 90 tonnes de carreaux cuits) environ 40 kg de zinc. La consommation d'énergie électrique strictement nécessaire pour l'électrodéposition reste négligeable; elle est au maximum de 7 kWh par tonne produite. Les tensions restent inférieures à 50 volts et les courants inférieurs à 15 mA par cm².

Il est certain qu'on pourrait placer plusieurs cellules d'électrolyse en parallèle pour augmenter la production si nécessaire.

**Revendications**

1. Procédé électrochimique pour la réalisation de carreaux céramiques individuels (4) ou intégrés dans un ensemble de carreaux céramiques (4a à 4d), sans moule ni estampage ultérieur d'un ruban de pâte, d'épaisseurs comprises entre 1 et 15 mm. et dont les formats par élément individuel peuvent s'inscrire dans des surfaces jusqu'à 1000×1000 mm:, les ensembles de carreaux étant du type "mosaïques", "vitraux", ou "puzzles", procédé comportant l'électrodéposition des matières premières en barbotine sur l'anode d'une cuve d'électrolyse et dans lequel on utilise une pluralité de membranes échangeuses d'ions ou semi-perméables ou de plaques métalliques planes ou profilées que l'on déplace individuellement dans la cuve d'électrolyse devant une cathode fixe, les dites membranes ou plaques étant sélectivement masquées à l'aide de peinture isolante ou de ruban auto-adhésif délimitant les contours des carreaux à réaliser.

2. Procédé selon la revendication 1, caractérisé en ce que les plaques métalliques planes ou profilées sont constituées de zinc, de matière galvanisée, de cuivre, de fer, d'aluminium ou de nickel.

3. Procédé selon la revendication 1, caractérisé en ce que la peinture est appliquée à l'aide d'un pochoir et d'un pinceau ou avec un dispositif de sérigraphie sur l'anode, les endroits de l'anode non recouverts définissant la forme du ou des carreaux fabriqués, les zones isolées déterminant les espaces vides autour, entre les carreaux ou des vides à l'intérieur de ceux-ci.

4. Procédé selon l'une quelconque des revendications 1 à 2, caractérisé en ce que l'on réalise des profilés en céramique d'épaisseur de 1 à 5 mm. comprenant des carreaux galbés, des équerres, des cornières, des coins, des éléments de claustra, des tubes droits ou coudés sur des tôles métalliques embouties, cintrées, pliées soudées.

5. Procédé selon l'une quelconque des revendications 1 à 3, caractérisé en ce qu'à l'aide d'anodes formées de tôles métalliques repoussées ou martelées ou de supports emboutis en polymère organique métallisées ou encore de plaques mégalliques modélées par électroformage ou électro-usinage, on réalise des "bas-reliefs" en céramique de 3 à 10 mm. d'épaisseur.

6. Procédé selon l'une quelconque des revendications 1 à 3, caractérisé en ce que la transposition sur la céramique de motifs en creux ou en relief, de gravures, de dessins, de textes, de photographies quelconques est réalisée après gravure préalable des plaques servant d'anode, cette gravure pouvant être effectuée soit mécaniquement soit par attaque acide par exemple par le procédé de l'eau forte ou par photogravure sur des plaques de zinc, de cuivre, de magnésium.

7. Procédé selon l'une quelconque des revendications à 3 ou 5, pour la reproduction de photographie éventuellement en couleurs caractérisé en ce qu'on applique des oxydes colorants des émaux ou des encres d'imprimerie aux carreaux après cuisson.

8. Procédé selon l'une quelconque des revendications 1 à 3 pour l'obention de reliefs atténués, caractérisé en ce qu'on utilise des anodes bimétalliques, notamment Zn-Cu, Zn-Al, Zn-Fe, Cu-Al, l'obtention du relief résultant de la différence de vitesses l'électrodéposition de la céramique selon la nature du métal ainsi que de la forme du dépôt d'une couche mince de métal d'apport sur la plaque support selon le motif à réaliser.

9. Procédé selon l'une quelconque des revendications 1 à 3, pour l'obtention de carreaux à surface rugueuse irrégulière, matte, caractérisé en ce qu'on utilise des anodes constituées de dépôts métalliques projetés à chaud au pistolet ou au chalumeau à plasma et par la technique du zinguage au pistolet à chaud sur support métallique ou en matière plastique.

10. Dispositif pour la mise en oeuvre du procédé selon l'une quelconque des revendications 1 à 8, lequel dispositif comprend une cuve d'électrolyse (5), un convoyeur (8) transportant des plaques (1) qui servent d'anodes dans la cuve d'électrolyse (5) et comportant un rail (9) de mise sous tension des plaques (1), un poste (11) d'égouttage et de lavage à l'eau, un poste (13) comportant des dalles réfractaires (12) poussées sur rouleaux, un four tunnel (14) de séchage et de cuisson, un poste de nettoyage et de reconditionnement (16) des plaques (1), la cuve d'électrolyse comportant une contre-électrode (10) servant de cathode, une entrée (6) de distribution et une évacuation (7) de barbotine, l'évacuation (7) étant agencée pour retourner la barbotine à la cuve d'électrolyse, le convoyeur (8) étant agencé de manière à transporter les plaques (1) dans la cuve d'électrolyse, à amener les plaques (1) chargées de carreaux céramiques crus (4) vers le poste (11) d'égouttage et de lavage à l'eau, puis vers le poste (13) où les carreaux (4), déposés sur les dalles réfractaires (12) et détachés des plaques (1), sont conduits vers le four tunnel (14), le convoyeur (8) entraînant ensuite les plaques (1) vers le poste de nettoyage et de reconditionnement (16) avant de les ramener vers la cuve d'électrolyse.

**Patentansprüche**

1. Elektrochemisches Verfahren zur Herstellung von einzelnen (4) oder in einen Verbund eingebetteten (4 a bis 4d) Keramikfließen ohne nachfolgende Gieß- oder Preßformung aus einem Werkstoffbreiband, und zwar mit Dicken zwischen 1 und 15 mm, wobei die einzelnen Elemente Abmessungen von bis zu 1000×1000 mm erreichen können und der Fließenverbund als "Mosaik", "Fenster" oder "Puzzle" ausgebildet ist, das Verfahren beinhaltet die Galvanisierung der Schlickerrohstoffe an der Anode einer Elektrolysewanne und die Verwendung mehrere Ionenaustauscher-Membrane oder halbdurchlässiger Membrane oder von flachen oder profilierten Metallplatten, die vor einer fest installierten Kathode einzeln in die Elektrolysewanne eingebracht werden; die genannten Membrane oder Platten werden mit Hilfe von Isolierfarbe oder Selbstklebeband, mit dem die Umrisse der zu fertigenden Fließen abgegrenzt werden, teilweise abgedeckt.

2. Verfahren nach Anspruch 1, bei dem die flachen oder profilierten Metallplatten aus Zink, verzinktem Werkstoff, Kupfer, Eisen, Aluminium oder Nickel bestehen.

3. Verfahren nach Anspruch 1, bei dem die Farbe mit Hilfe einer Schablone und eines Pinsels oder mit einer Serigraphievorrichtung auf die Anode aufgebracht wird, wobei die nicht abgedeckten Stellen der Anode die Form der gefertigten Fließe(n) bestimmen und die abgedeckten Stellen die Aussparungen um die Fließen herum oder zwischen den Fließen oder die Aussparungen innerhalb der Fließen selbst bedingen.

4. Verfahren nach einem der Ansprüche 1 bis 2, bei dem 1 bis 5 mm dicke Keramikprofile, die gewölbte Fließen, Winkel, Leisten, Eckstücke, Unterteilungselemente, gerade oder bogenförmige Röhren umfassen, auf tiefgezogenen rundgebogenen, gefalteten, geschweißten Metallblechen ausgeführt werden.

5. Verfahren nach einem der Ansprüche 1 bis 3, bei dem mit Hilfe von Anoden, die aus flach geprägten oder getriebenen Metallblechen oder tiefgezogenen, metallüberzogenen Trägern aus organischem Polymer oder aber aus elektrogeformten oder elektrobearbeiteten Metallplatten bestehen, Keramik-Tiefreliefs mit einer Stärke von 3 bis 10 mm ausgeführt werden.

6. Verfahren nach einem der Ansprüche 1 bis 3, bei dem die übertragung von Tief- oder Hochreliefmotiven, von Drucken, Zeichnungen, Texten und Photographien jeglicher Art nach der vorherigen Gravierung der als Anode dienenden Platten durchgeführt wird; diese Gravierung kann entweder mechanisch oder durch Ätzung beispielsweise nach dem Ätzdruckverfahren oder durch Heliogravüre auf den Zink-, Kupfer- oder Megnesiumplatten erfolgen.

7. Verfahren nach einem der Ansprüche 1 bis 3 oder 5 zur Reproduktion von Photographien (gegebenenfalls in Farbe), bei dem nach dem Brennvorgang Farboxide, Glasuren oder Druckfarben auf die Fließen aufgebracht werden.

8. Verfahren nach einem der Ansprüche 1 bis 3 zur Erzielung von Flachreliefs, bei dem Bimetallanoden insbesondere aus Zn-Cu, Zn-Al, Zn-Fe und Cu-Al verwendet werden und das Relief durch die unterschiedlichen Galvanisierungsgeschwindigkeiten der Keramik je nach Art des Metalls sowie nach der Form der Abscheidung einer dünnen, plattierten Metallschicht auf der Trägerplatte in Abhängigkeit von gewünschten Motiv erzielt wird.

9. Verfahren nach einem der Ansprüche 1 bis 3 zur Erzielung von Fließen mit einer unregelmäßigen, matten, rauhen Oberfläche, bei dem Anoden mit Metallbeschichtungen verwendet werden, die mit einer Pistole oder mit einem Plasmabrenner und nach dem Feuerverzinkverfahren auf dem Metall- oder Kunststoffträger flammgespritzt werden.

10. Vorrichtung zum Einsatz des Verfahrens nach einem der Ansprüche 1 bis 8, die umfaßt: eine Elektrolysewanne (5), eine Fördereinrichtung (8) zur Beförderung der in der in der Elektrolysewanne (5) als Anode dienenden Platten (1), eine Schiene zum Unterspannungsetzen der Platten (1), eine Abtropf- und Wasserspülstation (11), eine Station (13) mit rollengeführten feuerfesten Beschickungsplatten (12), einen Tunnelofen (14) zum Trocknen und Brennen und ein Reinigungs- und Rekonditionierungsstation (16) für die Platten (1); die Elektrolysewanne enthält eine Gegenelektrode (10), die als Kathode dient, einen Schlickerzulauf (6) und einen Schlickerablauf (7), wobei der Ablauf (7) zur Rückführung des Schlickers zur Elektrolysewanne dient; die Fördereinrichtung dient zur Beschickung der Elektrolysewanne mit den Platten (1) und zum Transport der Platten (1) mit den Keramikfließen-Rohlingen (4) zur Abtropf- und Wasserspülstation (11) und dann zu der Station (13), bei der die Fließen (4) auf den feuerfesten Beschickungsplatten (12) abgelegt, von den Platten (1) abgelöst und dann dem Tunnelofen (14) zugeführt werden; die Fördereinrichtung transportiert anschließend die Platten (1) zur Reinigungs- und Rekonditionierungsstation (16) bevor diese erneut zur Elektrolysewanne geleitet werden.

## Claims

1. An electrochemical process for making ceramic tiles, individually (4) or incorporated in ensembles of thin ceramic tiles (4a to 4d), without the use of a mould or further stamping of a paste strip, of between 1 to 15 mm thickness, whereby the sizes of each individual elements may be included in a surface of up to 1000×1000 mm, the said ensembles of tiles being of the type 'mosaic', 'lead-glass window' or 'puzzles', said process comprising electrodeposition of raw materials in the form of a slip, on the anode of an electrolysis cell or tank wherein there is used a plurality of ion-exchange or semipermeable membranes or planar or contoured metallic plates which are moved individually in the electrolysis cell in front of a fixed cathode, said membranes or plates being selectively masked with isolating paints or adhesive tape delimiting the contours of the tiles to be produced.

2. A process in accordance with claim 1 wherein the planar or contoured metallic plates are made of zinc, galvanised materials, copper, iron, aluminium or nickel.

3. A process in accordance with claim 1, characterised by the fact that paint is applied with a stencil-plate and a brush or by silk screening on the anode and in which the uncovered regions of the anodes determine the form(s) of the tile(s) to be produced, the isolated parts defining the empty spaces around, between or inside said tiles.

4. A process in accordance with claims 1 and 2, characterised by the fact there are provided ceramic shaped pieces of 1 to 5 mm thickness comprising curved tiles, right angles tiles, corner tiles, elements of close to tiles, 'cloisters' elements, straight tubes or bent tubes on metallic embossed, curved, folded or welded sheet metals.

5. A process in accordance with claims 1 to 3 characterised by the fact there is obtained ceramic bas-reliefs of 3 to 10 mm thickness using anodes made of embossed or hammered metallic plates or galvanised embossed support of organic polymers or metal plates shaped by electroforming or electromachining.

6. A process in accordance with claim 1 to 3 characterised by the fact transposition on ceramic of hollow or relief motifs, engravings, drawings, texts, photographs is made after engraving the plates used as anodes, such engraving being made mechanically or by acid attack for example using the process of etching or photoengraving onto zinc, copper or magnesium plates.

7. A process in accordance with any one of the claims 1 to 3 or 5, for reproducing photographs possibly in colors, characterised by the fact there is applied color oxides, enamels or printing ink on the tiles after firing.

8. A process in accordance with any one of the claims 1 to 3 wherein there is obtained attenuated reliefs, characterised by the fact there is used bimetallic anodes, in particular Zn-Cu, Zn-Al, Zn-Fe, Cu-Al the relief being produced by the difference in ceramic electrodeposition velocities due to the nature of the metal or the form of the deposit of a thin layer of supplemental metal on the plate in accordance with the desired motif.

9. A process in accordance with any of the claims 1 to 3 wherein there is obtained tiles with a rough, irregular and unpolished surface characterised by the fact there are used anodes consisting of metallic deposits laid down with a spray gun or plasma torch and by the techniques of galvanising with a hot spray gun on a metallic or plastic support.

10. Apparatus for carrying out the process in accordance with claims 1 to 8, such apparatus comprising an electrolysis cell or tank (5), a conveyor (8) transporting plates (1) used as anodes into the electrolysis tank, a rail (9) for applying electric voltage to said plates, a drip tray (11) and a water spray station, a station (13) with refractory floor tiles (12) moving on rollers, a tunnel furnace (14) for drying and firing, a cleaning and reconditioning station (16) of plates (1), the electrolysis tank comprising a counter-electrode (10) used as cathode, an entry for distribution and an exit for the slip, said exit being placed in such a way as to return the slip into the electrolysis tank, the conveyor being such that plates are moved into the electrolysis tank, and that plates with the green tiles thereon (4) are transported to the dripping and water cleaning station, then towards station (13) wherein the tiles (4), laid on refractory floor tiles and detached from the plates (1) are transported into the tunnel furnace (14), the conveyor (8) moving then the plates (1) towards the cleaning and reconditioning station (16) before returning said plates towards the electrolysis tank.

FIG1a

FIG1b

FIG2a

FIG2b

FIG2c

FIG2d

FIG 3a

FIG 3b

FIG 3c

FIG 3d

FIG 3d'

FIG 3e

FIG 4